Europäisches Patentamt

European Patent Office

Office européen des brevets

(19)

(11) Veröffentlichungsnummer : **0 130 139**
**B1**

(12)

# EUROPÄISCHE PATENTSCHRIFT

(45) Veröffentlichungstag der Patentschrift :
09.09.87

(21) Anmeldenummer : 84730067.0

(22) Anmeldetag : 15.06.84

(51) Int. Cl.⁴ : **H 03 K 17/78**

(54) Schaltungsanordnung zur potentialfreien Erfassung von binären elektrischen Signalen.

(30) Priorität : 23.06.83 DE 3322696

(43) Veröffentlichungstag der Anmeldung :
02.01.85 Patentblatt 85/01

(45) Bekanntmachung des Hinweises auf · die Patenterteilung : 09.09.87 Patentblatt 87/37

(84) Benannte Vertragsstaaten :
AT BE CH DE IT LI NL SE

(56) Entgegenhaltungen :
DE-A- 3 107 742
GB-A- 2 067 866
PATENTS ABSTRACTS OF JAPAN, Band 5, Nr. 19 (E-
44)(691), 4. Februar 1981
ELECTRICAL DESIGN NEWS, Band 18, Nr. 22, 20.
November 1973, Seiten 26-32, Denver, US; T. MAZUR:
"Solid-state relays offer new solutions to many old
problems"
IBM TECHNICAL DISCLOSURE BULLETIN, Band 18,
Nr. 11, April 1976, Seite 3545, New York, US; D.G.
BINGHAM et al.: "Current sensor"

(73) Patentinhaber : Siemens Aktiengesellschaft Berlin
und München
Wittelsbacherplatz 2
D-8000 München 2 (DE)

(72) Erfinder : Kühne, Wolfgang
Gartenfelder Strasse 56
D-1000 Berlin 20 (DE)

EP 0 130 139 B1

**Beschreibung**

Die Erfindung betrifft eine Schaltungsanordnung zur potentialfreien Erfassung von binären elektrischen Signalen unterschiedlicher Impulshöhe mittels eines Optokopplers, dessen Eingang über einen Strombegrenzungswiderstand mit den Eingangsanschlüssen der Schaltungsanordnung verbunden ist.

Eine derartige Schaltungsanordnung ist in RPB-electronictaschenbücher Nr. 308, 1978 (G. Blaise : « 20 Experimente mit optoelektronischen Schaltungen ») auf Seite 72 ff beschrieben. Die bekannte Anordnung (siehe Abbildung 16.3) enthält einen Optokoppler, dessen eingangsseitige Leuchtdiode über einen Strombegrenzungswiderstand zwischen den Eingangsanschlüssen der bekannten Schaltungsanordnung liegt ; ausgangsseitig wird der Fototransistor des Optokopplers als Emitterfolger betrieben, wobei der Fototransistor über einen Lastwiderstand im Emitterzweig an eine Betriebsspannung angeschlossen ist. Die zu erfassenden binären elektrischen Signale steuern die Helligkeit der Leuchtdiode, wobei diese durch den Strombegrenzungswiderstand gegen zu hohe Spannungen geschützt ist ; entsprechend der Helligkeitsänderung der Leuchtdiode ändert sich der Widerstand der Kollektor-Emitter-Strecke des Fototransistors, so daß am Ausgang des Optokopplers eine Spannung zur Verfügung steht, die den zu erfassenden elektrischen Signalen entspricht und von diesen potentialmäßig getrennt ist.

Der Strombegrenzungswiderstand muß hinsichtlich der jeweiligen Impulshöhe der zu erfassenden binären Signale so gewählt sein, daß einerseits ein genügend hoher Steuerstrom durch die Leuchtdiode des Optokopplers fließt und andererseits diese nicht durch einen zu hohen Strom überlastet wird. Bei Signalen mit großer Impulshöhe sind die in dem Strombegrenzungswiderstand auftretenden Verluste so hoch, daß sie insbesondere bei Anordnung mehrerer der bekannten Schaltungsanordnungen in einer Baugruppe zu einer erheblichen Erwärmung führen können.

Der Erfindung liegt die Aufgabe zugrunde, eine Schaltungsanordnung mit einem Optokoppler zur potentialfreien Erfassung binärer elektrischer Signale anzugeben, mit der sich Signale verschiedener und auch sehr großer Impulshöhe ohne Bereichsumschaltung erfassen lassen und bei der die auftretende Verlustleistung besonders gering ist.

Zur Lösung dieser Aufgabe ist bei der Schaltungsanordnung der eingangs beschriebenen Art erfindungsgemäß zwischen den Eingangsanschlüssen in Reihe mit dem Eingang des Optokopplers und dem Strombegrenzungswiderstand eine Steuerschaltung angeordnet, die bei Ansteuerung einen Strom in den Eingang des Optokopplers einspeist ; zwischen den Eingangsanschlüssen ist eine Vorrichtung zur Spannungsbegrenzung angeordnet, die an ihrem Ausgang aus den binären Signalen abgeleitete Signale mit normierter Höhe abgibt. Weiterhin ist zwischen dem Ausgang der Vorrichtung zur Spannungsbegrenzung und dem Steuereingang der Steuerschaltung eine durch Tastimpulse steuerbare Torschaltung zur Abtastung der abgeleiteten Signale geschaltet ; der Ausgang des Optokopplers ist mit dem Eingang einer Speichereinrichtung verbunden, in der die bei einer Einspeisung des Stromes in den Eingang des Optokopplers am Eingang der Speichereinrichtung vorliegende Spannung mindestens für die Zeitdauer zwischen zwei aufeinander folgenden Tastimpulsen gespeichert wird und am Ausgang der Speichereinrichtung zur Verfügung steht.

Ein wesentlicher Vorteil der erfindungsgemäßen Schaltungsanordnung besteht darin, daß der Optokoppler nicht direkt mit den zu erfassenden binären elektrischen Signalen angesteuert wird, sondern daß in Reihe mit seinem Eingang eine Steuerschaltung angeordnet ist, die von aus den binären Signalen abgeleiteten Signalen mit normierter Höhe angesteuert wird und bei Ansteuerung einen Strom in den Eingang des Optokopplers einspeist ; dadurch ist der Strom zur Ansteuerung des Optokopplers unabhängig von der Impulshöhe der zu erfassenden binären elektrischen Signale, so daß sich mit der erfindungsgemäßen Schaltungsanordnung in vorteilhafter Weise Signale verschiedener Impulshöhen ohne Bereichsumschaltung erfassen lassen.

Ein weiterer wesentlicher Vorteil der erfindungsgemäßen Schaltungsanordnung besteht darin, daß die insgesamt auftretende Verlustleistung besonders gering ist, weil die durch die Tastimpulse steuerbare Torschaltung die abgeleiteten Signale kurzzeitig abtastet und die Abtastwerte dem Steuereingang der Steuerschaltung zuführt. Infolgedessen wird der Optokoppler in vorteilhafter Weise nur während der kurzen Dauer eines Tastimpulses durch den Strom der Steuerschaltung angesteuert, während in der tastfreien Zeit die Stromaufnahme der erfindungsgemäßen Schaltungsanordnung vernachlässigbar ist. Die dem Ausgang des Optokopplers nachgeschaltete Speichereinrichtung erzeugt in vorteilhafter Weise aus den von dem Optokoppler übertragenen Signalen eine Ausgangsspannung, die durch ihren Verlauf die zum Zeitpunkt der Tastimpulse vorliegenden binären Zustände der zu erfassenden binären elektrischen Signale wiedergibt, wobei die Ausgangsspannung diesen binären Zustand mindestens bis zum jeweils nächsten Tastimpuls beibehält.

Bei einer vorteilhaften Ausführungsform der erfindungsgemäßen Schaltungsanordnung ist die Steuerschaltung ein Transistor, der mit dem Strombegrenzungswiderstand als Emitterfolger geschaltet ist. Wegen der gegenkoppelnden Wirkung des Strombegrenzungswiderstandes ist nämlich der Steuerstrom in den Eingang des Optokopplers unablängig von der Impulshöhe der zu erfassenden binären elektrischen Signale, so daß der Optokoppler bei Signalen mit großer Impulshöhe gegen Überlastung geschützt ist. Ein weiterer Vorteil liegt in dem einfachen und daher kostengünstigen Aufbau dieser Anordnung.

Besonders günstig ist es, wenn der Eingang des Optokopplers zwischen dem Emitteranschluß des Transistors und dem Strombegrenzungswiderstand liegt und parallel zu der Basis-Emitter-Strecke des Transistors und dem Eingang des Optokopplers ein weiterer Widerstand geschaltet ist ; beim Übergang des Transistors in den sperrenden Zustand können dann in vorteilhafter Weise die Ladungen aus der Basis des Transistors über den weiteren Widerstand abfließen, wobei der Spannungsabfall an dem Eingang des Optokopplers den Abfluß der Ladungen beschleunigt. Dadurch wird das Schaltverhalten des Transistors wesentlich verbessert.

Bei einer weiteren vorteilhaften Ausgestaltungsform der erfindungsgemäßen Schaltungsanordnung ist im Hinblick auf einen möglichst einfachen und kostengünstigen Schaltungsaufbau die Vorrichtung zur Spannungsbegrenzung eine Reihenschaltung aus einem Vorwiderstand und einer Zenerdiode.

Es hat sich als vorteilhaft erwiesen, wenn parallel zu der Zenerdiode ein Kondensator geschaltet ist. Dieser liefert nämlich für die kurze Dauer der Tastimpulse den notwendigen Strom zur Steuerung der Steuerschaltung, so daß die aus dem Vorwiderstand und der Zenerdiode bestehende Vorrichtung zur Spannungsbegrenzung kaum belastet wird. Daher kann in vorteilhafter Weise der Vorwiderstand sehr groß gewählt werden, so daß in der tastfreien Zeit die Stromaufnahme der erfindungsgemäßen Schaltungsanordnung besonders gering ist.

Als steuerbare Torschaltung zur Abtastung der abgeleiteten Signale können beispielsweise bipolare Transistoren oder Feldeffekttransistoren eingesetzt werden. Im Hinblick auf eine potentialmäßige Trennung des Steuereingangs der Torschaltung von den zu erfassenden binären elektrischen Signalen ist es jedoch von Vorteil, wenn die Torschaltung ein weiterer Optokoppler ist, der als Serientor geschaltet ist.

Für die Ausführung der Speichereinrichtung bieten sich mehrere Möglichkeiten an ; im Hinblick auf einen möglichst einfachen Aufbau erscheint es jedoch vorteilhaft, wenn die Speichereinrichtung ein Delay-Flip-Flop ist, das von den Tastimpulsen derart gesteuert wird, daß an seinem Ausgang die zum Zeitpunkt eines Tastimpulses vorliegende Spannung am Eingang des Delay-Flip-Flops für die Dauer bis zum nächsten Tastimpuls zur Verfügung steht.

Der Aufbau der erfindungsgemäßen Schaltungsanordnung läßt sich noch weiter vereinfachen, wenn als Speichereinrichtung ein nachtriggerbares Monoflop eingesetzt wird, weil bei diesem eine Steuerung durch die Tastimpulse entfällt. Die Rückfallzeit des Monoflops muß größer oder gleich der Zeit zwischen zwei aufeinander folgenden Tastimpulsen sein, damit die Spannung am Ausgang des Monoflops den zum Zeitpunkt eines Tastimpulses erfaßten binären Zustand des zu erfassenden binären Eingangssignals wiedergibt und bis zu dem jeweils nächsten Tastimpuls hält.

Bei einer weiteren vorteilhaften Ausführungsform der erfindungsgemäßen Schaltungsanordnung ist dem Steuereingang des weiteren Optokopplers ein Differenzierglied vorgeschaltet. Damit besteht die Möglichkeit, den weiteren Optokoppler mit den Flanken der Tastimpulse anzusteuern, so daß die Dauer der Tastimpulse im Hinblick auf eine geringe Stromaufnahme der erfindungsgemäßen Schaltungsanordnung besonders kurz ($< 2\mu s$) sein kann.

Zur Erläuterung der Erfindung ist in

Figur 1 ein Blockschaltbild der erfindungsgemäßen Schaltungsanordnung, in

Figur 2 ein Ausführungsbeispiel der erfindungsgemäßen Schaltungsanordnung nach Figur 1 und in

Figur 3 ein Zeitdiagramm von Signalen an verschiedenen Stellen der Schaltungsanordnung nach Figur 2 dargestellt.

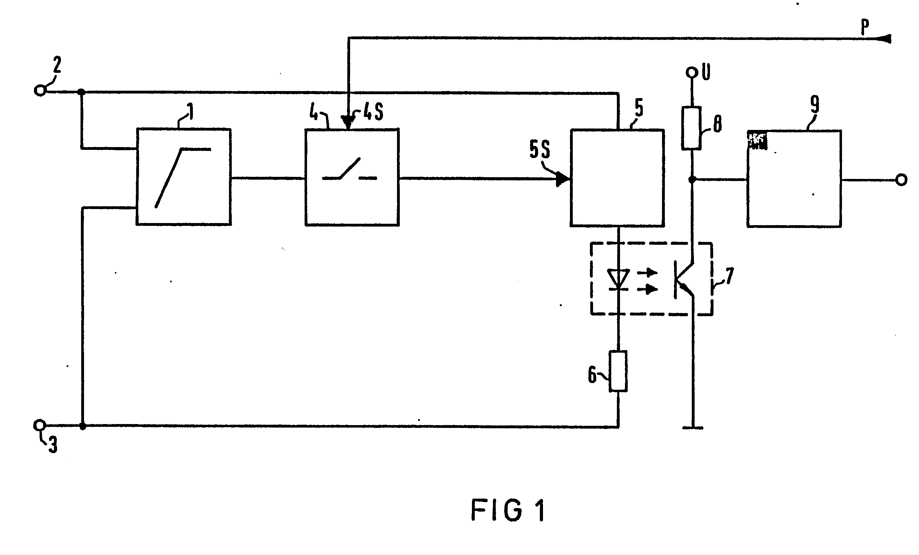

Das Blockschaltbild der erfindungsgemäßen Schaltungsanordnung nach Figur 1 enthält eine Vorrichtung zur Spannungsbegrenzung 1, die eingangsseitig mit den Eingangsanschlüssen 2 und 3 der Schaltungsanordnung zur Erfassung der binären elektrischen Signale verbunden ist. Der Ausgang der Vorrichtung zur Spannungsbegrenzung 1 ist mit dem Eingang einer Torschaltung 4 verbunden, der über einen Steuereingang 4S Tastimpulse P zugeführt werden. Die erfindungsgemäße Schaltungsanordnung enthält weiterhin eine Steuereinrichtung 5, deren Steuereingang 5S mit dem Ausgang der Torschaltung 5 verbunden ist ; der Ausgang der Steuereinrichtung 5 liegt in Reihe mit einem Strombegrenzungswiderstand 6 und dem Eingang eines Optokopplers 7 zwischen den Eingangsanschlüssen 2 und 3 der Schaltungsanordnung. Der Ausgang des Optokopplers 7 ist in Emitterschaltung über einen Kollektorwiderstand 8 an eine Betriebsspannung $U_B$ geschaltet und weiterhin an den Eingang einer Speichervorrichtung 9 angeschlossen.

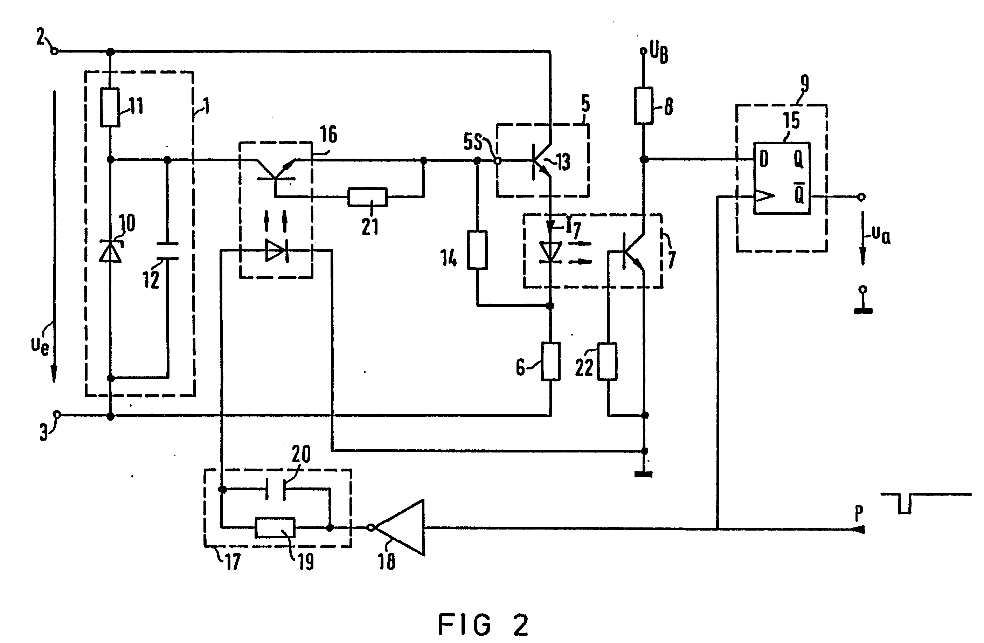

Bei dem Ausführungsbeispiel der erfindungsgemäßen Schaltungsanordnung nach Figur 2 enthält die Vorrichtung zur Spannungsbegrenzung 1 eine Zenerdiode 10, die in Reihe mit einem Vorwiderstand 11 zwischen den Eingangsanschlüssen 2 und 3 der Schaltungsanordnung liegt ; parallel zu der Zenerdiode 10 ist ein Kondensator 12 angeordnet. Die Steuerschaltung 5 besteht aus einem Transistor 13, der mit dem Strombegrenzungswiderstand 6 als Emitterfolger zwischen die Eingangsanschlüsse 2 und 3 der Schaltungsanordnung geschaltet ist, wobei der Eingang des Optokopplers 7 zwischen dem Emitteranschluß des Transistors 13 und dem Strombegrenzungswiderstand 6 liegt und parallel zu der Basis-Emitter-Strecke des Transistors 13 und dem Eingang des Optokopplers 8 ein weiterer Widerstand 14 geschaltet ist. Der Optokoppler 7 ist ausgangsseitig in Emitterschaltung über den Kollektorwiderstand 8 mit der Betriebsspannung $U_B$ verbunden und an den Eingang D der Speichereinrichtung 9 angeschlossen, die aus einem von den Tastimpulsen P gesteuerten Delay-Flip-Flop 15 besteht.

Zwischen dem Ausgang der Vorrichtung zur Spannungsbegrenzung 1 und dem Steuereingang 5S der Steuerschaltung 5 ist ein weiterer Optokoppler 16 als steuerbare Torschaltung mit der Kollektor-Emitter-Strecke seines Fototransistors angeordnet. An den von der Leuchtdiode des weiteren Optokopplers gebildeten Steuereingang ist ein Differenzierglied 17 angeschlossen, dem ein Inverter 18 vorgeordnet ist. Das Differenzierglied 17 besteht aus einem Widerstand 19 und einem parallel geschalteten Kondensator 20. Der Eingang des Inverters 18 ist an einen die Tastimpulse P abgebenden, nicht dargestellten Impulsgenerator angeschlossen. Der zeitliche Abstand der Tastimpulse P ist im Vergleich zu ihrer Dauer groß gewählt.

Die beiden in dem dargestellten Ausführungsbeispiel enthaltenen Optokoppler 7 und 16 weisen zusätzlich einen Basisanschluß auf, der jeweils über einen Widerstand 21 bzw. 22 mit dem Emitteranschluß des Fototransistors verbunden ist.

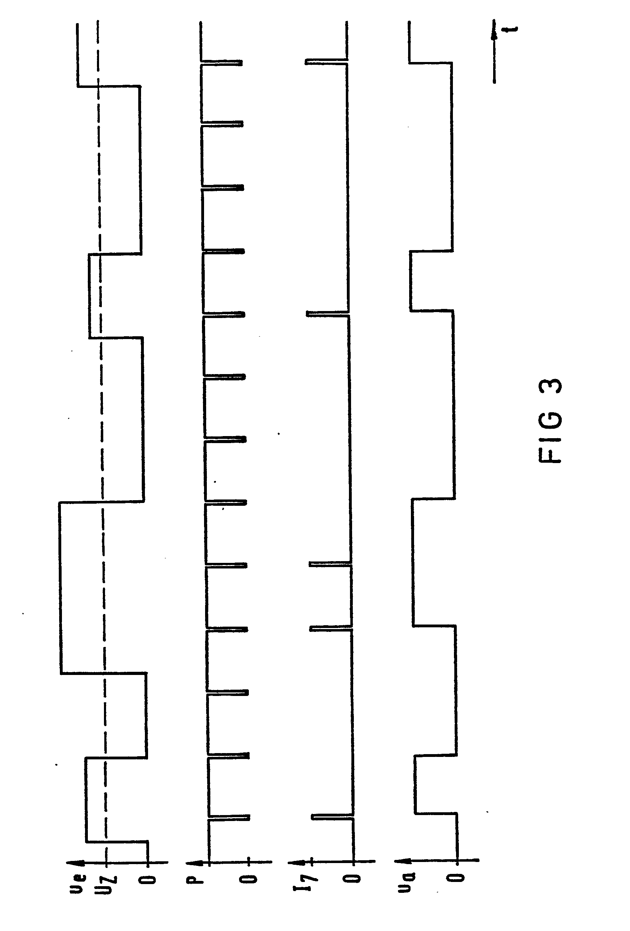

Anhand des Ausführungsbeispiels nach Figur 2 und der in Figur 3 dargestellten Zeitdiagramme wird die Funktionsweise der erfindungsgemäßen Schaltungsanordnung erläutert.

Aus den an den Anschlußklemmen 2 und 3 der erfindungsgemäßen Schaltungsanordnung anliegenden binären elektrischen Signalen $u_e$ werden in der Vorrichtung zur Spannungsbegrenzung 1, bestehend aus dem Vorwiderstand 11 und der Zenerdiode 10, entsprechende Signale abgeleitet, deren Höhe unabhängig von der Impulshöhe der binären elektrischen Signale auf die Zenerspannung $U_Z$ der Zenerdiode 10 normiert ist. Der als Serientor geschaltete weitere Optokoppler 16 wird über den Inverter 18 und das nachgeschaltete Differenzierglied 17, bestehend aus dem Kondensator 20 und dem Widerstand 19, mit der jeweiligen Vorderflanke der in diesem Ausführungsbeispiel low-aktiven Tastimpulse P gesteuert; dabei tastet der weitere Optokoppler 16 als steuerbare Torschaltung die normierten elektrischen Signale kurzzeitig ab und führt die Abtastwerte der normierten Signale dem Steuereingang 5S der nachgeordneten Steuerschaltung 5 zu. Der zeitliche Abstand zwischen zwei aufeinander folgenden Tastimpulsen muß kleiner oder gleich der kürzesten Dauer eines binären Zustandes der zu erfassenden binären Signale $u_e$ sein, damit diese von der erfindungsgemäßen Schaltungsanordnung ohne Informationsverlust erfaßt werden. Um die Belastung der Vorrichtung zur Spannungsbegrenzung 1 möglichst gering zu halten, ist parallel zu der Zenerdiode 10 der Kondensator 12 geschaltet, der während der Zeitdauer der Tastimpulse jeweils dann den erforderlichen Steuerstrom für die Steuerschaltung 5 liefert, wenn das abgeleitete Signal seinen hohen Pegel mit der auf die Zenerspannung $U_Z$

der Zenerdiode 10 normierten Höhe aufweist. In den Pausen zwischen zwei aufeinander folgenden Tastimpulsen und bei niedrigem Pegel des abgeleiteten Signals wird die Steuerschaltung 5 nicht angesteuert.

Besitzt das abgeleitete elektrische Signal zum Abtastzeitpunkt seinen hohen Pegel, so steuert der Transistor 13 der Steuerschaltung 5 aufgrund des seiner Basis zugeführten Steuerstroms den Eingang des Optokopplers 7 mit einem impulsförmigen Strom $I_7$ an (vgl. Figur 3). Dieser ist unabhängig von der Impulshöhe der zu erfassenden binären Signale, weil der Transistor 13 mit dem Strombegrenzungswiderstand 6 als Emitterfolger geschaltet ist. Entsprechend dem impulsförmigen Strom $I_7$ in den Eingang des einen Optokopplers 7 ändert dessen Fototransistor den Widerstand seiner Kollektor-Emitter-Strecke, so daß an dem Ausgang des Optokopplers 7 den impulsförmigen Eingangsströmen entsprechende Spannungsimpulse zur Verfügung stehen. Die Spannungsimpulse am Ausgang des Optokopplers 7 werden von dem nachgeschalteten impulsgesteuerten Delay-Flip-Flop 15 mit der jeweiligen positiven Rückflanke jedes Tastimpulses übernommen und für die Dauer bis zum nächsten Tastimpuls an den Ausgang Q des Delay-Flip-Flops 15 durchgeschaltet. An dem invertierenden Ausgang $\overline{Q}$ des Delay-Flip-Flop 15 steht damit eine Spannung $u_a$ zur Verfügung, deren Verlauf die zum Zeitpunkt der Tastimpulse vorliegenden binären Zustände der zu erfassenden binären Signale wiedergibt, wobei die Spannung $u_a$ den jeweiligen binären Zustand bis zum jeweils nächsten Tastimpuls beibehält.

Handelt es sich bei den Tastimpulsen P um high-aktive Signale, so ist es zweckmäßig, wenn der Inverter 17 entfällt und das Delay-Flip-Flop ein negativ flankengesteuertes Delay-Flip-Flop ist.

## Patentansprüche

1. Schaltungsanordnung zur potentialfreien Erfassung von binären elektrischen Signalen unterschiedlicher Impulshöhe mittels eines Optokopplers (7), dessen Eingang über einen Strombegrenzungswiderstand (6) mit den Eingangsanschlüssen (2 und 3) der Schaltungsanordnung verbunden ist, dadurch gekennzeichnet, daß zwischen den Eingangsanschlüssen (2 und 3) in Reihe mit dem Eingang des Optokopplers (7) und dem Strombegrenzungswiderstand (6) eine Steuerschaltung (5) angeordnet ist, die bei Ansteuerung einen Strom in den Eingang des Optokopplers (7) einspeist, daß zwischen den Eingangsanschlüssen (2 und 3) eine Vorrichtung zur Spannungsbegrenzung (1) angeordnet ist, die an ihrem Ausgang aus den binären Signalen abgeleitete Signale mit normierter Höhe abgibt, daß zwischen dem Ausgang der Vorrichtung zur Spannungsbegrenzung (1) und dem Steuereingang der Steuerschaltung (5) eine durch Tastimpulse (P) steuerbare Torschaltung (4) zur Abtastung der abgeleiteten Signale geschaltet ist und daß der Ausgang des Optokopplers (7) mit dem Eingang einer Speichereinrichtung (9) verbunden ist, in der die bei einer Einspeisung des Stromes in den Eingang des Optokopplers am Eingang der Speichereinrichtung (9) vorliegende Spannung mindestens für die Zeitdauer zwischen zwei aufeinander folgenden Tastimpulsen gespeichert wird und am Ausgang der Speichereinrichtung (9) zur Verfügung steht.

2. Schaltungsanordnung nach Anspruch 1, dadurch gekennzeichnet, daß die Steuerschaltung (5) ein Transistor (13) ist, der mit dem Strombegrenzungswiderstand (6) als Emitterfolger geschaltet ist.

3. Schaltungsanordnung nach Anspruch 2, dadurch gekennzeichnet, daß der Eingang des Optokopplers (7) zwischen dem Emitteranschluß des Transistors (13) und dem Strombegrenzungswiderstand (6) liegt und daß parallel zu der Basis-Emitter-Strecke des Transistors (13) und dem Eingang des Optokopplers (7) ein weiterer Widerstand (14) geschaltet ist.

4. Schaltungsanordnung nach einem der vorangehenden Ansprüche, dadurch gekennzeichnet, daß die Vorrichtung zur Spannungsbegrenzung (1) eine Reihenschaltung aus einem Vorwiderstand (11) und einer Zenerdiode (10) ist.

5. Schaltungsanordnung nach Anspruch 4, dadurch gekennzeichnet, daß parallel zu der Zenerdiode (10) ein Kondensator (12) geschaltet ist.

6. Schaltungsanordnung nach einem der vorangehenden Ansprüche, dadurch gekennzeichnet, daß die Torschaltung (4) ein weiterer Optokoppler (16) ist, der als Serientor geschaltet ist.

7. Schaltungsanordnung nach einem der vorangehenden Ansprüche, dadurch gekennzeichnet, daß die Speichervorrichtung (9) ein Delay-Flip-Flop (15) ist, das von den Tastimpulsen (P) gesteuert wird.

8. Schaltungsanordnung nach einem der vorangehenden Ansprüche, dadurch gekennzeichnet, daß die Speichereinrichtung (9) ein nachtriggerbares Monoflop ist.

9. Schaltungsanordnung nach Anspruch 6, dadurch gekennzeichnet, daß dem Steuereingang des weiteren Optokopplers (4) ein Differenzierglied (18) vorgeordnet ist.

## Claims

1. A circuit arrangement for d. c. -isolated detection of binary electrical signals of different pulse levels by an opto-coupler (7) whose input is connected via a current-limiting resistor (6) to the input terminals (2 and 3) of the circuit arrangement, characterised in that a control circuit (5) is arranged between the input terminals (2 and 3) in series with the input of the opto-coupler (7) and the current-limiting resistor (6) to feed a current into the input of the opto-coupler (7) when actuated ; that a voltage-limiting device (1) arranged between the input terminals (2 and 3) emits signals of standardized level at its output, derived from the binary signals ; that a gate circuit (4) controlled by keying pulses (P) is connected between the output of the voltage-limiting device (1) and the control input of the control circuit (5) to sample the derived signals, and that the output of the opto-coupler (7) is connected to the input of a storage device (9) in which the voltage which occurs at the input of the storage device (9) when the current is fed into the input of the opto-coupler is stored at least for the time between two consecutive keying pulses, and is available at the output of the storage device (5).

2. A circuit arrangement as claimed in Claim 1, characterised in that the control circuit (5) is a transistor (13) which is connected to form an emitter-follower stage with the current-limiting resistor (6).

3. A circuit arrangement as claimed in Claim 2, characterised in that the input of the opto-coupler (7) is located between the emitter terminal of the transistor (13) and the current-limiting resistor (6) and that a further resistor (14) is connected parallel to the base-emitter path of the transistor (13) and the input of the opto-coupler (7).

4. A circuit arrangement as claimed in one of the preceding Claims, characterised in that the voltage-limiting device (1) is a series arrangement composed of a series resistor (11) and a Zener diode (10).

5. A circuit arrangement as claimed in Claim 4, characterised in that a capacitor (12) is connected parallel to the Zener diode (10).

6. A circuit arrangement as claimed in one of the preceding Claims, characterised in that the gate circuit (4) is a further opto-coupler (16) connected as a series gate.

7. A circuit arrangement as claimed in one of the preceding Claims, characterised in that the storage device (9) is a delay flipflop (15) controlled by the keying pulses (P).

8. A circuit arrangement as claimed in one of the preceding Claims, characterised in that the storage device (9) is a retriggerable monoflop.

9. A circuit arrangement as claimed in Claim 6, characterised in that the control input of the further opto-coupler (4) is preceded by a differentiator (18).

## Revendications

1. Montage pour la détection, à potentiel libre, de signaux électriques binaires sous forme d'impulsions possédant des amplitudes différentes, à l'aide d'un optocoupleur (7), dont l'entrée est reliée par l'intermédiaire d'une résistance (6) de limitation du courant aux bornes d'entrée (2 et 3) du montage, caractérisé par le fait qu'entre les bornes d'entrée (2 et 3) se trouve disposé, en série avec l'entrée de l'optocoupleur (7) et la résistance (6) de limitation du courant, un circuit de commande (5) qui, sous l'effet d'une commande, injecte un courant dans l'entrée de l'optocoupleur (7), qu'entre les bornes d'entrée (2 et 3) se trouve monté un dispositif (1) servant à limiter la tension et qui délivre, sur sa sortie, des signaux dérivés des signaux binaires et possédant une amplitude normalisée, qu'un circuit de porte (4), qui peut être commandé par des impulsions de commande (P) et sert à échantillonner les signaux dérivés, est branché entre la sortie du dispositif (1) servant à limiter la tension et l'entrée de commande du circuit de commande (5), et que la sortie de l'optocoupleur (7) est reliée à l'entrée d'un dispositif de mémoire (9) dans lequel la tension présente à l'entrée du dispositif de mémoire (9) dans le cas de l'injection du courant à l'entrée de l'optocoupleur est mémorisée au moins pendant l'intervalle de temps s'étendant entre deux impulsions de commande successives et est disponible à la sortie du dispositif de mémoire (9).

2. Montage suivant la revendication 1, caractérisé par le fait que le circuit de commande (5) est un transistor (13), qui est raccordé en tant qu'émetteur suiveur à la résistance (6) de limitation du courant.

3. Montage suivant la revendication 2, caractérisé par le fait que l'entrée de l'optocoupleur (7) est située entre la borne d'émetteur du transistor (13) et la résistance (6) de limitation du courant et qu'une autre résistance (14) est branchée en parallèle avec la voie base-émetteur du transistor (13) et l'entrée de l'optocoupleur (7).

4. Montage suivant l'une des revendications précédentes, caractérisé par le fait que le dispositif (11) servant à limiter la tension est constitué par un montage série formé d'une résistance additionnelle (11) et d'une diode Zener (10).

5. Montage suivant la revendication 4, caractérisé par le fait qu'un condensateur (12) est branché en parallèle avec la diode Zener (10).

6. Montage suivant l'une des revendications précédentes, caractérisé par le fait que le circuit de porte (15) est un optocoupleur supplémentaire (16) qui est branché en tant que porte fonctionnant en série.

7. Montage suivant l'une des revendications précédentes, caractérisé par le fait que le dispositif de mémoire (9) est une bascule bistable (15) produisant un retard et qui est commandée par les impulsions de commande (P).

8. Montage suivant l'une des revendications précédentes, caractérisé par le fait que le dispositif de mémoire (9) est un multivibrateur monostable redéclenchable.

9. Montage suivant la revendication 6, caractérisé par le fait qu'un circuit différentiateur (18) est disposé en amont de l'entrée de commande de l'optocoupleur supplémentaire (4).

FIG 1

0 130 139

FIG 2

0 130 139

FIG 3